# EUROPEAN PATENT APPLICATION

(11) **EP 2 660 352 A1**
(43) Date of publication of application: **06.11.2013**
(21) Application number: 12166340.5
(22) Date of filing: 02.05.2012
(51) Int. Cl.: C23C 14/28

(54) **Donor sheet and method for light induced forward transfer manufacturing**

(71) Applicant: Nederlandse Organisatie voor Toegepast -Natuurwetenschappelijk Onderzoek TNO, 2628 VK Delft (NL); IMEC, 3001 Leuven (BE)
(72) Inventor: Meinders, Erwin Rinaldo, 2628 VK Delft (NL); Fledderus, Henri, 2628 VK Delft (NL); Prenen, An Maria, 2628 VK Delft (NL)
(74) Representative: Jansen, Cornelis Marinus

(57) **Abstract**

A light induced forward transfer manufacturing method provides for transfer of material from a donor sheet (14). A donor sheet is used that comprises a trench in a surface of the donor sheet, with transfer material in the trench. The material is transferred by scanning a light spot along the bottom of the trench. A donor sheet is used in which the average depth of the trench varies in the scanning direction. This supports optical reading of position information from the trench through the donor sheet and/or transfer of structures with predetermined height profiles from the trench. In combination with the average depth, or by themselves, a trench width, deviation of a trench from an average track or variation of a thickness or composition of material at a bottom of the trench may vary as a function of position along the trench to support optical reading of position information and/or transfer of predetermined structures.

## Description

### Field of the invention

The invention relates to a method of manufacturing structure by means of light induced forward transfer and to a donor sheet for use in this method.

### Background

Laser induced forward transfer (also known as LIFT) is a well known process to apply material to a structure under manufacture. In a laser induced forward transfer process donor material is transferred from a donor sheet to selected locations on a structure under manufacture. The surfaces of the structure and the donor sheet are placed adjacent each other and the donor sheet is heated locally by means of a laser spot. The heating causes donor material to detach from the donor sheet, and to launch the detached material onto the structure under manufacture.

WO2009/153792 discloses a LIFT process wherein the donor sheet comprises a transparent substrate with trenches filled with donor material. The trenches may be coated with a solvent before adding the donor material. The laser beam irradiates the donor material in a trench through a transparent layer. This results in the creation of a gas between the substrate and the donor material in the trench, causing the donor material to be released and transferred to the structure under manufacture. WO2009/153792 notes that this approach makes it possible to release donor material of greater height with a relatively low power laser, compared to the case wherein a continuous sheet of donor material is used. The width and position of the transferred material is determined by the width and position of the trench, even if the laser spot size is wider than the trench or not accurately aligned with the trench.

WO2009/153792 notes that the use of filled trenches makes it possible to use other forms of light instead of a laser beam. A trench may have limited length, or it may be interrupted, so that the trench forms one or more pits filled with donor material. This eases release of the donor material and it provides for more accurate definition of the material in the length direction as well as the width direction of the trench.

### Summary

Among others, it is an object to provide for a manufacturing structure that comprises laser induced forward transfer wherein the position of the light beam on the donor sheet can be accurately and reproducibly determined and/or more complex structures can be transferred.

According to an aspect a method of manufacturing a structure by means of light induced forward transfer of material from a donor sheet onto the structure, wherein the donor sheet comprises a trench in a surface of the donor sheet, the trench comprising donor material, wherein least one of an average trench depth, an average trench width, a deviation of a trench from an average track or a thickness or composition of material at a bottom of the trench varies as a function of position along the trench. Known variations may be used for example to read out position information to help determine the location of a light spot that lights the bottom of the trench or to provide for transfer of donor material of selectable height and/or width or a selectable pattern of height and/or width variation that is known to be defined by the donor sheet. A plurality of donor sheets for light induced forward transfer may each be provided with the same pattern of variation of one or more of the indicated properties, to enable read out of position information and/or transfer of predetermined patterns of heights and/or widths from each.)

A trench with variable depth enables detection by means of light reflected from the bottom of the trench and transfer of donor material with position dependent height. As used herein the term "average" trench depth excludes reliance on depth values that are not characteristic for the depth of the trench, such as the depth at arbitrary points on the edge of a trench. The average may be the average depth in a cross-section through the trench transverse to a longest direction of the trench. Similarly, a trench with variable composition or (i.e. and/or) thickness of material at the bottom of the trench enables detection by means of light reflected from the bottom of the trench. Similarly, a trench with variable width enables detection by means of light reflected from the bottom of the trench and transfer of donor material with position dependent width. As in the case of depth, the term "average" trench width excludes reliance on width values that are not characteristic for the width of the trench, such as the width between arbitrary points on the edge of a trench. The average may be the average width in a cross-section through the trench transverse to a longest direction of the trench. A trench deviations from an average track (known as wobble e.g. for compact disks) may be similarly used. Here the average track may be a linear track or circle arc, the average being over a length of the track.

In an embodiment the method comprises the steps of claim 2. Herein sensing of variation of trench depth, width, track deviation or composition or thickness from the bottom of the trench is used to collect information to help select a position where the intensity of the light source is raised in order to cause transfer of donor material Depth variations may be detected from optical interference or phase delays for example, width variations may be detected from reflection intensity variation, track deviations may be detected from tracking, composition or layer thickness variations may be detected from reflected intensity, optionally at selected wavelengths. As used herein increasing the intensity covers both increasing from zero intensity as increasing from a lower non-zero intensity level that is insufficient to cause transfer.

In an embodiment a same light beam is used both for optical sensing and to induce the forward transfer of the donor material. Thus no additional beam is required for sensing. Sensing can be performed both when there is no transfer (with a lower intensity beam) and during transfer (with a higher intensity beam). The sensing result may also be used to determine when to stop transfer. In another embodiment, beams of different wavelength may be used. This has the advantage that material can be used that is highly absorptive material at the wavelength of the LIFT beam with useful reflection at the wavelength of the read beam.

The depth and width may be used to provide binary information, by detecting transitions between a first and second depth. Alternatively, information may be decoded using a form of information demodulation, for example demodulation of frequency, phase or amplitude modulation of periodic variations of trench depth or width. The donor sheet may comprise labels that distinguish different trenches or trench parts each trench part having its own unique pattern of variation, e.g. a forming binary number. As used herein, unique means that the same pattern does not occur more than once on the same donor sheet.

However, the identification need not be unique. In an embodiment phase of periodic the depth width or deviation variation may be used to determine a phase of the variations (i.e. position relative to a reference phase), which can be used to select target locations located at predetermined phase positions.

A donor sheet according to claim 8 is provided. The donor sheet may have the form of a disk for example, with a circular or spiral trench that can be scanned by rotating the disk. In another embodiment linear trenches may be used or a disk or rectangular shaped donor sheet for example. The donor sheet makes it possible to perform the method. In the donor sheet the depth and/or width of the trench may vary as a function of position along a longest direction of the trench. Thus, depth variations can be measured while a light spot is canned along the length of the trench. This also facilitates transfer of a predetermined position dependent height pattern of donor material. In an embodiment the depth of the trench may vary as a function of position transverse to a longest direction of the trench. This facilitates transfer of a predetermined position dependent transverse height pattern of donor material.

In an embodiment different parts of the trench and/or different trenches with donor material in the donor sheet have mutually different patterns of variation of said property, the patterns uniquely distinguishing the different parts and/or different trenches in the donor sheet.

In an embodiment the donor sheet mutually different donor material in mutually different trenches and/or trench parts at mutually different locations on the donor sheet. This makes it possible to transfer different materials accurately using on donor sheet. In an embodiment a plurality of layers of mutually different donor material may be provided in at least a part of the trench. This makes it possible to transfer an accurately defined layer structure. In an embodiment the donor sheet comprises a first donor material only in deeper parts of the trench and a second donor material over the donor material in the deeper parts and in the less deep parts.

A method of manufacturing a donor sheet is provided, the method comprising molding a transparent substrate from a master that defines a trench of variable height in the substrate and at least partially filling the trench with donor material Thus many donor sheets may be manufactured at low cost.

### Brief description of the drawing

These and other advantageous aspects will become apparent from a description of exemplary embodiment using the following figures.
Figure 1 shows a cross section of a LIFT arrangement during manufacturing
Figure 2 shows a detailed cross section of a donor sheet
Figure 3 shows a control system
Figure 4 shows a flow chart of beam position control
Figure 5a-f shows examples of cross-sections of a donor sheet
Figure 6 shows cross-sections of a trench
Figure 7 show cross-sections of a trench

### Detailed description of exemplary embodiments

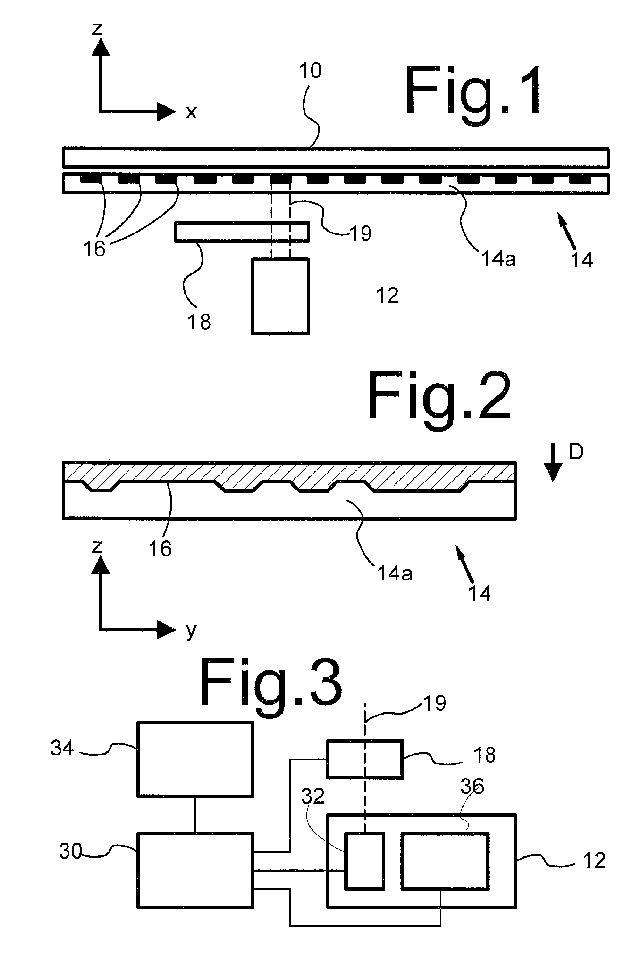

Figure 1 shows a cross section of a LIFT arrangement during manufacture (not to scale). The arrangement comprises a structure under manufacture 10, a light source 12 and a donor sheet 14 located between light source 12 and structure 10. Light source 12 may be a laser light source, for example, which produces a laser beam. A monitoring unit 18 is located between light source 12 and donor sheet 14. Structure 10 may be an object, like a wafer, that initially has a substantially flat surface. Structure 10 and donor sheet 14 have surfaces that face each other. The planar directions along the surface will be referred to as the xy directions and the direction perpendicular to the surface will be called the z direction. The cross-section of figure 1 is through an xz plane.

Preferably the surfaces of donor sheet 14 and structure 10 are not in direct contact, there being a narrow space between the surfaces that separates the surfaces. Donor sheet 14 comprises a transparent substrate 14a with trenches 16 (shown in cross-section) extending into the substrate from the surface of donor sheet 14 that faces structure 10. Transparent substrates are known per se for LIFT arrangements. Transparent substrates 14a may be made of polymer material like polycarbonate, or of glass or any other transparent solid. Transparent substrate 14a may have a thickness of around one millimeter or in a range of 0.1 to 10 millimeter for example.

Transparent substrate 14a should be transparent at least between its back surface (the surface opposite the surface that contains trenches 16) and the bottom of trenches 16. Preferably transparent substrate 14a is also transparent for light in at least one wavelength range in areas between successive trenches 16, so that structure 10 is visible through donor sheet. This makes it possible to measure the position of features on structure 10 relative to donor sheet 14 by means of light transmitted through donor sheet 14 in such areas.

The trenches may have a width in a range of 0.1 to 10 micrometer for example, or 0.5 to 5 micrometer and a depth in a range of 0.5 to 5 micrometer for example. Trenches 16 are at least partly filled with donor material. The donor material may be any type of material, e.g. electrically conductive material such as a metal, or in ink that contains conductive particles, but electrically isolating materials may be used as well. Trenches 16 may contain more than one material. For example in an embodiment a layer of auxiliary material is provided between the donor material and the bottom of the trench 16. The auxiliary material may be used to assist in lifting the donor material, through expansion of the auxiliary material and possibly melting or evaporation due to heating. Such auxiliary materials are known per se. Polyimide or triazine may be used for example.

In operation light source 12 directs a beam 19 of light to donor sheet 14, forming a light spot at least on the bottom of a trench. Beam 19 passes through transparent substrate 14a and heats material on the bottom of the trench. This causes at least part of the material to be transferred from donor sheet 14 to the surface of structure 10. In an embodiment, donor material is provided directly on the bottom of trench 16, the donor material being transferred as a result of expansion and possibly partial melting or evaporation due to heating. In the embodiment wherein a layer of auxiliary material is provided, the donor material may be transferred as a result of expansion of the auxiliary material and possibly melting or evaporation due to heating.

The position of beam 19 is scanned relative to donor sheet 14, for example in the y-direction. The combination of structure 10 and donor sheet 14 may be moved while light source 12 remains fixed, or light source 12 may be moved while donor sheet 14 remains fixed or a moving mirror or other moving optics may be used to scan beam 19 form light source 12 for example.

In an embodiment, a tracking mechanism may be used to keep the spot centered on trench 16 in the direction transverse to the scanning direction (the x-direction). Tracking mechanisms from DVD/CD technology may be used, comprising a detector with a plurality of detection areas, arranged e.g. as quadrants in a rectangle, from each of which areas a signal is generated that depends on the light intensity in the area, differentials between the signals being used to control an actuator that moves the spot transverse to the scanning direction.

Figure 2 shows a cross section of donor sheet 14, the cross section being taken through a yz plane, that is, a plane perpendicular to the xz plane of cross-section of figure 1. Trench 16 is shown along its length in the y-direction. The depth D of trench 16 in the z direction varies as a function of position y along the length.

When, in operation, beam 19 is scanned relative to donor sheet 14 in the y-direction the position of the resulting light spot on the bottom of trench 16 moves along the y-direction. Monitoring unit 18 detects an effect of the resulting variation of the depth at which the spot impinges on the bottom of trench 16. The depth variation may result in a detectable reflection intensity variation due to the reflection. Monitoring unit 18 may comprise a detector to detect reflected light intensity variations. The detectable intensity variations may be a result of variable interference, a variable amount of reflection and/or a variable direction of reflection.

For example when beam 19 reflects light from different sides of a transition between different depth levels of trench 16, interference may occur between different light that has been reflected from parts of the trench 16 that have different depth. To detect this, monitoring unit 18 may comprise a detector to detect light intensity variations due to interference in the reflected light. Pulse shaped variations may be detected at transitions. To facilitate this type of detection, trench 16 preferably comprises depth levels that differ by approximately a quarter wavelength of the light of beam 19 (or approximately a quarter wavelength plus an integer number of half wavelengths) and trench has transitions between these levels that are shorter than the spot diameter of beam 19. As long as the depth differences are not exactly an integer number of half wavelengths, detectable interference may occur.

In another embodiment monitoring unit 18 may comprise an interferometer arrangement configured to measure variation in interference between light reflected from the bottom of trench 16 and light from beam 19 that has been reflected from a reference surface, such as the top surface of donor sheet 14 in which trenches 16 are provided. In this embodiment a beam with a diameter larger than the width of trench 16 may be used, e.g. twice the width. The intensity of the reflected light is a result of interference between light reflected from the surface of donor sheet 14 and from the bottom of trench 16. Therefore, the intensity may vary as a result of depth variations of trench 16 when the beam and the donor sheet are scanned relative to each other along the length of the trench.

In another embodiment, monitoring unit 18 may provide for an interferometer arrangement that comprises a splitter that splits of part of the beam intensity and directs split parts to the bottom of trench 16 and to the reference surface respectively, a combiner that combines reflected light from the bottom and the reference surface and a detector to detect the intensity of the combined light. In this case the reference surface may be part of donor sheet 14, or it may be located outside donor sheet 14 in monitoring unit 18.

When the bottom of a trench 16 has a spatially variable depth gradient, e.g. a sinusoidal gradient with a period that is substantially longer than the spot diameter and the wavelength of beam 19, the direction of reflection of the beam from the bottom of the trench will vary. Monitoring unit 18 may contain one or more detectors located at a selected angle or angles from the position at which beam 19 is aimed. In this case, monitoring unit 18 may detect when beam 19 illuminates trench16 at a position with a gradient within a predetermined range of angles, or it may detect variation of detected intensity due to changes of the gradient.

When the trench comprises islands of donor material, interrupted by areas of the same depth as the surface of donor sheet 14, monitoring unit 18 may use a detector to detect intensity variations of the reflected light due to interference between light reflected by the donor material in trench 16 and the surface of donor sheet 14. Even if successive islands have the same length and width, a difference between the depth of different islands will result in different interference conditions and hence in differences in the detected intensity for different islands. This makes it possible to combine the use islands of the same well defined width and length for lift with reading of information.

In an embodiment, a first and second material of different reflectivity may be used at different positions on the bottom of trench, for example in relatively deeper parts and relatively less deep parts respectively. The first and second material may be different coatings on the bottom of the trench, or the first material may be a coating and the second material may be donor material. In this embodiment monitoring unit 18 may use a detector to detect intensity variations of the reflected light form the first and second material.

Figure 3 shows an embodiment of a control system of the LIFT arrangement. The control system comprises a computer 30, a beam scanning mechanism 32, monitoring unit 18, beam generator 36 and optionally a donor sheet moving mechanism 34. Beam scanning mechanism 32 and beam generator 36 may be part of light source 12. Beam scanning mechanism 32 is configured to scan beam 19 relative to donor sheet 14, e.g. along the y direction. Donor sheet moving mechanism 34 is configured to move donor sheet 14 relative to structure 10. Beam scanning mechanism 32 may comprise a movable mirror to deflect beam 19 art variable angles, or a rotating polygon, or an actuator (e.g. a table coupled to a motor) to move beam generator 36 and/or donor sheet 14 and structure 10, for example. Donor sheet moving mechanism 34 serves to move donors sheet 14 and structure 10 relative to each other in at least the x direction and preferably also the y direction, or rotate donors sheet 14 or structure 10 around a z-axis. Donor sheet moving mechanism 34 may comprise a table for carrying donor sheet 14, coupled to a motor for moving the table relative to structure 10, and/or a similar mechanism to move structure 10. Optionally donor sheet moving mechanism 34 may be combined with beam scanning mechanism 32.

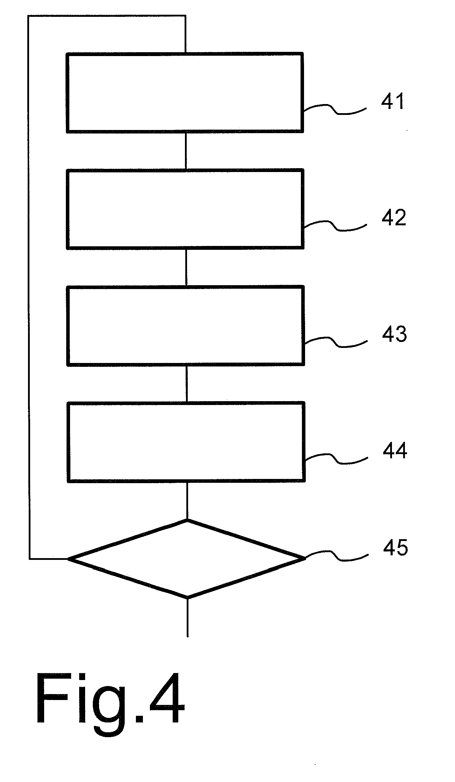

Computer 30 is coupled to beam scanning mechanism 32, monitoring unit 18, light source 12 and optionally donor sheet moving mechanism 34. Computer 30 may be a part of monitoring unit 18. Computer 30 may be a general purpose computer provided with a computer readable medium with instructions to perform the steps described in relation to figure 4.

Figure 4 shows a flow chart of beam position control. The steps of this flow chart may be executed by computer 30. Computer 30 makes use of a data file that defines positions on structure 10 to which donor material must be transferred. Furthermore, computer 30 makes use of a record of locations on donor sheet 14 where donor material is available.

In a first step 41, computer 30 uses the data file to select a location or a series of successive locations on structure 10 to which donor material must be transferred and to which no donor material has yet been transferred. In a second step 42, computer 30 uses the record to select a location or a series of successive locations on donor sheet 14 from which donor material must be transferred and from which no donor material has yet been transferred.

In a third step 43 causes donor sheet moving mechanism 34 to move donor sheet 14 and substrate 10 relative to each other, so that the selected location or series of successive locations on donor sheet 14 faces the selected location or a series of successive locations on structure 10. Alternatively, for example if donor sheet moving mechanism 34 continually rotates donor sheet 14, computer 30 may wait until the selected locations face each other.

During the movement and/or prior to the movement computer 30 causes light source 12 to generate a light beam of relatively lower intensity, which is insufficient to cause transfer of donor material. Computer 30 receives information from monitoring unit 18 that indicates detected depth or changes in depth of trench 16 as result of movement of beam 19 relative to donor sheet. From this information, computer 30 determines at least part of a current position of the beam spot on donor sheet 14. Computer 30 may use this information to determine which of the trenches is currently illuminated by beam 19 and/or which position within a track is currently illuminated by beam 19. Computer 30 adjusts the movement or waiting time according to the difference and the selected location on donor sheet 14, so that the selected location or series of successive locations on donor sheet 14 will face the selected location or a series of successive locations on structure 10.

In a fourth step 44, executed when the selected location or series of successive locations on donor sheet 14 face the selected location or a series of successive locations on structure 10, computer 30 causes light source to increase the intensity of the beam to a relatively higher intensity, which is sufficient to cause donor material to be transferred. Beam 19 may be scanned relative to donor sheet 14 during this step in order to transfer material from the selected location or series of successive locations on donor sheet 14. Also during transfer computer may continue to receive information from monitoring unit 18 that indicates detected depth or changes in depth of trench 16 as a result of scanning. Computer 30 may use this information to select a time point at which it causes light source 12 to lower the beam intensity to the relatively lower intensity to stop transfer. This may be used even if third step 43 does not use the depths or depth changes for positioning.

In a fifth step 45, computer 30 records information in relation to the data file and the record to indicate that donor material has been transferred from the selected locations on donor sheet 14 to the selected locations on structure 10. In a sixth step 45, computer 40 tests whether all locations on structure 10 indicated in the data file have received donor material. If not, computer 30 repeats the process from first step 41.

Computer 30 may identify the sensing position on the donor sheet by using the sensed information to look up position information in a table of positions, or the sensed information may directly represent position information. The movement mechanism may be controlled by changing a voltage applied to an actuator like a motor. The light source may similarly be controlled by changing an electric voltage applied to the light source.

The same type of donor sheet 14, with the same pattern of trenches, may be used for manufacturing different structures. In this case, different structure specific data files may be used to define different sets of locations to which donor material may be transferred. In this case, the process allows locations on the donor sheet for different structures to be selected differently dependent on the data file. Moreover, the same donor sheet may be used for a plurality of structures, the selection of locations on the donor sheet for transfer to a structure being adapted dependent on the locations that have been used for previous structures.

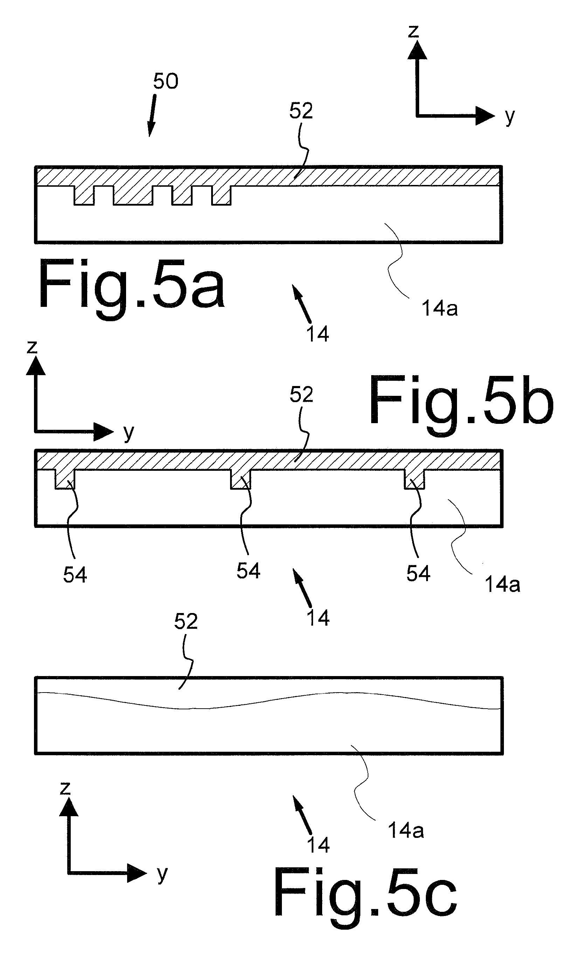

Figure 5a shows an example of a donor sheet in cross-section. In this example, the depth of the trench with donor material 52 has a pattern 50 of transitions between a first and second non-zero depth that encodes binary information, such as an address of a trench and/or a section of a trench the location on donor sheet. In an embodiment, deeper parts of different length in pattern 50 may represent ones and zeros respectively, or the depths at different distances from a start of pattern 50 may represent ones and zeros. Computer 30 may use detection of these depth variations during scanning of beam 19 along the y direction relative to donor sheet 14, to distinguish the currently illuminated trench from other trenches on donor sheet 14 and/or to distinguish a section of the trench. The binary information may represent a code number that uniquely identify the trench and/or a section of the trench. In an embodiment a part of the trench with the binary pattern may be followed in the "y" direction by a part of the trench that has constant depth, the part with constant depth having a greater length than the part with the binary pattern.

Figure 5b shows an example wherein the depth of the trench has periodic variations 54, with periodic transitions between a first and second non-zero depth. Computer 30 may use detection of these transitions during scanning of beam 19 along the y direction relative to donor sheet 14 to monitor progress of scanning. Figure 5c shows an example wherein the depth of the trench has periodic sinusoidal depth variations between non zero maximum and minimum depths, without discrete steps. Detection of these variations can be used in the same way as the variations of figure 5b, but it allows for a more sensitive detection for example when only a small amplitude of depth variations is used to minimize the effect on transfer of donor material. In a further embodiment the sinusoidal variations may be used to encode binary information like that of figure 5a, for example by using sinusoidal depth variations with a modulated spatial frequency or phase variation. Known signal frequency or phase modulation techniques may be used. Although sinusoidal variations are shown, it will be appreciated that other analog variations may be used. In this embodiment, a detection method may be used that measures the effect of the variable depth relative to a reference. In an embodiment a spot size is used to track the groove, the spot size having a larger diameter (than the groove width, for example twice the groove width. In this way reflection from the surface of donor sheet 14 adjacent trench 16 may be used as a reference. In a further embodiment mutually different first and second spot sizes are used, the first for tracking, and the second for writing.

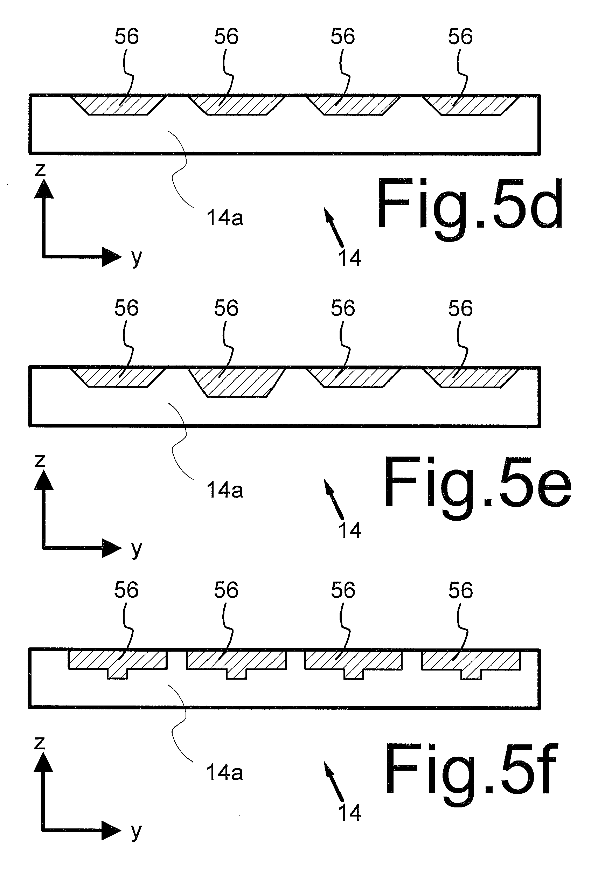

Figure 5d shows an example wherein interruptions may are used in a trench, so that the trench is separated into a series of pits 56 with donor material in the y direction. In this case a zero depth may be used between the pits 56, that is, substrate 14a may have the same level between pits in the y direction as adjacent pits in the x direction. In other words, the surface of substrate 14a may comprise a closed contour around of constant height. In this case, monitoring unit 18 may indicate the variations between the zero depth between pits 56 and the depth in a pit 56 when the beam is scanned in the y direction along the pits 56. The pattern of these variations may be used to determine the position of the spot of light beam 19 e.g. in third step 43.

Figure 5e shows a combination of interruptions and variations between different non-zero depths between the interruptions. Different ones of pits 56 may be given mutually different depths, e.g. by using pits of a first and second depth. In this embodiment, the pattern of depths of different pits may be used to represent an address or a period that computer 30 may use to determined the position of the spot of light beam 19 e.g. in third step 43. In an embodiment islands with surface areas of different size, e.g. with different length may be used, sets of islands of a first size and a second size that are mutually different being used in a first trench and a second trench respectively, or in different sections of a trench or in different areas on donor sheet. In this case different non-zero depths of islands of the same surface size may be used to read out information.

Monitoring variation between different non-zero depths as in figures 5a-c has the advantage that detection techniques can be used that do not require reflection from the surface of donor sheet 14 between islands to determine the position. This makes it possible to determine positions also within ranges of locations where donor material is present, or where other material is present in trenches and it makes it easier to use a transparent donor sheet adjacent the trenches. Use of pits of different depth has the advantage that no surface area need be sacrificed for coding information compared to the case where pits of the same depth are used. Light reflected from the top of donor sheet 14 and light reflected from the bottom of the trenches may be used for phase modulation. In that case, different depths give rise to different modulation levels.

Figure 5f shows a combination of interruptions and use of different depths in different parts of the trench. In either case, computer 30 may use depth variations between different non-zero depths to collect information about the trench.

Although examples have been described wherein trench depth variations are used to encode information, it should be appreciated that other aspects of the trench may also be varied for this purpose. For example, use may be made of width variations or a wobble (distinguishing different trenches by means of different deviations between the longitudinal centre lines of the trench and a predetermined line such as a straight line along the y direction or a circle arc). Use of wobbles is known per se from optical storage (CD, DVD). In this case, the data pattern may be represented in a wobble, the frequency of the wobble being used to determine the clock frequency, phase changes in this wobble signal being used to encode addresses.

These aspects may be detected by monitoring unit 18, for example from variations in the intensity of light reflected from the bottom of the trench and/or from a tracking circuit that keeps the beam spot centered on the bottom of the trench. As noted, tracking circuits, e.g. with sensors that detect reflected light as a function of position, are known per se from CD and DVD players.

Depth variation and/or variation of the other aspects of the trench enable reading of information about the trench with donor material from the trench itself without need for further structures on donor sheet 14. One aspect may be used on its own to provide information, or different aspect may be used in combination. The use of depth variation has the advantage that it does not require xy plane variations of the trench that might affect transfer accuracy.

Although in one embodiment the same beam may be used both for reading information and lifting, in another embodiment light source 12 may be configured to generate a first and second light beam, the first beam for reading and/or tracking, the second beam for lifting. The first and second beam may be laser beams of mutually different wavelength and/or different beam diameter.

In one embodiment the beam for lifting may have a wavelength in an absorption band of the donor material, or of the auxiliary material at the bottom of trench 16, whereas the beam for reading may have a wavelength outside such a band. At least the absorption at the wavelength of the beam for lifting may be higher than at the wavelength of the beam for reading. This makes it possible to obtain higher reflectivity for reading information. However, even if the same wavelength is used absorbing material may still have sufficient reflectivity to detect depth variations.

In an embodiment trench 16 may be divided into islands of donor material, using islands of different size, sets of islands of a first size and a second size that are mutually different being used in a first trench and a second trench respectively, or in different sections of a trench or in different areas on donor sheet. In this embodiment, different spot sizes may be used for reading information from differences, e.g. in the depths of the islands, within different sets.

In an embodiment the spot diameter of the reading/tracking beam may be smaller than or the same as the trench width, whereas the spot diameter of the lift beam may be larger than the width of the trench. In another embodiment, the spot diameter of the reading/tracking beam is larger than the trench width, e.g. twice as large, to enable use of reflections from the surface of donor sheet 14 as a reference. In a further embodiment the spot diameter of the reading/tracking beam is smaller than distance between adjacent trenches on donor sheet 14.

In an embodiment the spot diameter of the write beam may be larger than the trench width, so that the trench width will define the accuracy of transferred patterns. The spot diameter of the write beam may be larger than the distance between adjacent trenches to enable writing from more than one trench simultaneously or smaller than the distance to provide for writing from one trench at a time. In an embodiment, the spot diameter of the reading/tracking beam may be the same as that of the writing beam. In another embodiment the spot diameter of the write beam may be of the same size as the trench dimension.

In an embodiment, light source 12 may be configured to switch to mutually different first and second intensity levels, the first level for reading information from trench 16 and/or tracking trench 16, and the second level, higher than the first level, for lifting the donor material from trench 16.

In other embodiments variation in trench width may be used to perform readout and/or tracking. In these embodiments a donor sheet is used that comprises a trench with a width (in the x-direction) that varies as a function of position in the scanning direction (y-direction). Monitoring unit 18 may be configured to detect width variations for example from variations of reflected intensity. The width may encode information in similar ways as the depth. However, width variations may affect the covered area of the structure under manufacture and it may require an increased distance between trenches 16.Similarly, variations in the composition or thickness of material at a bottom of the trench 16 may be used to represent information. For example, materials with mutually different reflectivity at a wavelength of beam 19 may be used at different positions along the y direction. For example, the composition and/or thickness of an auxiliary layer between the donor material and the bottom of the trench may be varied as a function of position in the y direction. Monitoring unit 18 may be configured to detect the resulting variations of reflected intensity. The composition and thickness may encode information in similar ways as the depth.

Trench depth variation may be used for other purposes as well. For example trenches of different (average) depth may be used to apply donor material of different or variable height on structure 10. More generally, variation in trench dimension such as height or width enables transfer of predefined high-resolution structures of variable size. In this type of embodiment, the data file may represent the desired heights or more generally dimensions at different locations on structure 10 and the record about donor sheet 14 may represent different available heights (trench depths) on donor sheet 14. Computer 30 may select a trench part for transfer to a selected location on structure 10 by selecting a trench part with a depth that corresponds to the height specified for the selected location on structure 10. Computer 30 may control donor sheet moving mechanism 34 to position a selected trench part facing the selected location on structure 10 and cause light intensity to be increased to transfer the part.

In another embodiment, trenches may provided with trench depth variation patterns that correspond to predetermined desirable material height variation patterns on structure 10. For example a height pattern structure 10 comprising a track wherein the height rises and drops along the length of the track in a locally higher ridge, in or a locally lower ridge. Another example may be a height pattern with a series of such ridges, e.g. for use as a grating. Another example may be a height pattern with a step in height with a predetermined height profile. One or more of these height variation patterns may be specified as predetermined types of patterns, that is, apart from their location. For each of the predefined types a number of trenches or trench parts with trench depth variation patterns corresponding to may be provided on donor sheet 14. When the donor sheet is manufactured, specific trenches on the donor need not be provided for specific locations on the structure.

In this embodiment, the data file may refer to the type of pattern in association with a location on structure 10 and the record about donor sheet 14 may represent locations of different available patterns of the predefined types on donor sheet 14. Computer 30 for a selected location on structure 10 computer 30 may use the type of pattern that is specified for that location in the data file to search for a trench part with a corresponding type in the record. Computer 30 may control donor sheet moving mechanism 34 to position the selected trench part facing the selected location on structure 10 and cause light intensity to be increased to transfer the part.

Height variations need not be limited to the longitudinal direction.

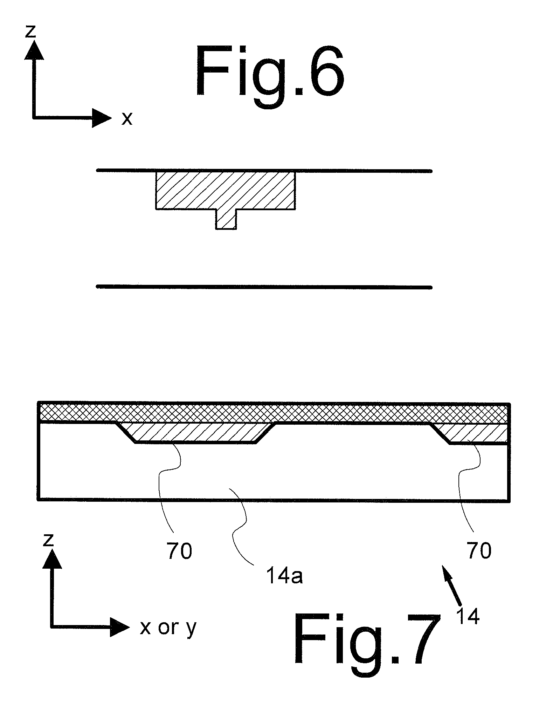

Figure 6 shows an xz cross section of donor sheet 14 in an embodiment wherein the height varies transverse to the longitudinal y-direction of a trench 60, i.e. transverse to the direction of scanning of the beam spot.

As will be appreciated, the use of trenches with different depths and/or predetermined depth variation patterns makes it possible to control the accuracy of the heights and/or height variations of the transferred material on structure 10 by means of the donor sheet, rather than by the accuracy of the beam spot size. Optionally, further height variations may be used to assist in locating the trenches or trench parts with the selected heights or height variations as described. In an embodiment such further height variations may be used as a synchronization pattern in a trench preceding a location of a pattern of a predetermined type, computer 30 being configured to cause the beam intensity to be raised a predetermined time interval after detection of the further height variations that serve as synchronization pattern.

Figure 7 shows an embodiment wherein a plurality of layers of mutually different donor material is provided in a trench. The depth of the trench varies between a non-zero first depth from the surface of donor sheet 14 and a second depth that is greater than the first depth. In parts 70 of the trench that have the second depth a first donor material is provided up to about the first depth, or al least not fully filling the trench. In the illustrated embodiment, the first donor material is not provided in the parts 70 of the trench that have the first depth. Everywhere in the trench a second donor material is provided, different from the first donor material. In the parts 70 of the trench that have the second depth, the second donor material overlies the first donor material. One of the donor materials may be a dielectric (electrically isolating material) and the other an electrical conductor for example. Or the materials may both contain a matrix of the same material but differ by the amount of added doping material. The materials may be materials with different optical properties (e.g. different wavelength absorption bands, i.e. colors, and/or different reflectivity, transmissiveness etc.)

On substrate 14a an auxiliary layer may be provided everywhere on the bottom of the trench, between the bottom and the first or second donor material, to assist in transfer. The combination of first and second donor materials may be used to transfer a multilayer donor structure from donor sheet 14 to the structure under manufacture in one step.

In this embodiment, the data file may refer to the type of layer structure in association with a location on structure 10 and the record about donor sheet 14 may represent locations of different available combinations of donor material on donor sheet 14. Computer 30 for a selected location on structure 10 computer 30 may use the type of layer structure that is specified for that location in the data file to search for a trench part with combination of donor materials in the record. Computer 30 may control donor sheet moving mechanism 34 to position the selected trench part facing the selected location on structure 10 and cause light intensity to be increased to transfer the part. Optionally, further height variations may be used to assist in locating the trenches or trench parts with the combination of donor material.

Various alternative processes may be used for manufacturing donor sheet 14. In an embodiment, donor sheet 14 may be manufactured by molding substrate 14a from a master that defines the trenches and their depths. A process similar to CD or DVD molding from a master may be used. Subsequently, donor material may be provided in the trenches of the substrate in liquid or plastic form and cured (hardened) in the trenches. Optionally, an auxiliary layer may be applied as a coating on the substrate prior to filling the trenches with donor material. The master may be manufactured by machining for example, leaving preform structures of the trenches with variable height corresponding to the variable depths of the trenches. Alternatively, the master could be manufactured using a photolithographic process by selective etching or deposition, and/or by printing layers on the surface of the master e.g. by means of inkjet printing or screen printing etch mask layers or deposition layers that define trenches.

In another embodiment donor sheet 14 itself may be manufactured at least partly using a photolithograph process and/or by printing. For example the trenches may be etched selectively at positions defined by a mask, using a plurality of etch steps with different masks to define different depths in the trenches. Donor material may be printed into the trenches. For example a first donor material may be printed selectively in part of the trenches and cured, followed by filling the remainder of the trenches with a second donor material and curing.

A plurality of donor sheets 14 may be used to manufacture different instances of products. Different types of donor sheets 14, with different variations of the properties of the trench may be provided. Donor sheets 14 of the same type each have the same pattern of variation of trench properties, so that given the specific type of the donor sheet 14 the LIFT arrangement is able to control manufacture in the same way, independent of which donor sheets 14 is used. Preferably, the size of the variations of the properties should exceed the range of variations that result from manufacturing tolerances, so that the same results in terms of information extraction and/or manufacturing will be obtained with different donor sheets 14 of the same type.

## Claims

1. A method of manufacturing a structure by means of light induced forward transfer of material from a donor sheet onto the structure, wherein the donor sheet comprises a trench in a surface of the donor sheet, the trench comprising donor material, wherein least one of an average trench depth, an average trench width, a deviation of a trench from an average track or a thickness or composition of material at a bottom of the trench varies as a function of position along the trench.

2. A method according to claim 1, the method comprising
- optically sensing a variation of a property of the trench as a function of sensing position on the donor sheet, the variation being sensed from reflection at least partly from a bottom of the trench towards a further surface of the donor sheet opposite to said surface;
- identifying the sensing position on the donor sheet dependent on information derived from said sensing.

3. A method according to claim 2, comprising using a same light beam both for said optical sensing and to induce forward transfer of the donor material, the intensity of the light beam being increased when a light spot of said light beam on the trench is at a target location position for forward transfer, as determined dependent on the identified sensing position.

4. A method according to claim 2, comprising using a first and second light beam for said optical sensing and to induce forward transfer of the donor material, respectively, the first and second light beam having mutually different wavelengths.

5. A method according to any one of claims 2-4, wherein said sensing comprises detecting transitions between first and second non-zero depth values of the trench from reflection of light from a bottom of the trench.

6. A method according to any one of the preceding claims, wherein the donor sheet comprises a set of a plurality of trench parts, each trench part with a pattern of variation of said property, different trench parts having different patterns, said identifying comprises identifying the trench part based on said pattern.

7. A method according to any one of claims 2-6, wherein said property has a periodic variation as a function of position along the trench, a target position being defined in terms of an offset relative to a reference phase in the periodic variation, wherein said identifying comprises identifying a phase of the sensing position relative to the reference phase.

8. A donor sheet for use in a light induced forward transfer of donor material, the donor sheet comprising a transparent substrate and a trench comprising donor material, the trench extending into the substrate from a surface of the donor sheet, wherein a property of the trench varies as a function of position on the donor sheet, the property being at least one of an average trench depth, an average trench width, a deviation of a trench from an average trench track or a thickness or composition of material at a bottom of the trench.

9. A donor sheet according to claim 8, wherein the depth, width or thickness or composition of material at a bottom of the trench varies as a function of position along a longest direction of the trench.

10. A donor sheet according to claim 8, wherein the property is a depth of the trench.

11. A donor sheet according to claim 10, wherein the depth of the trench varies as a function of position transverse to a longest direction of the trench.

12. A donor sheet according to any one of claims 8-11, wherein different parts of the trench and/or different trenches with donor material in the donor sheet have mutually different patterns of variation of said property, the patterns uniquely distinguishing the different parts and/or different trenches in the donor sheet.

13. A donor sheet according to any one of claims 8-12, comprising mutually different donor material in mutually different trenches and/or trench parts at mutually different locations on the donor sheet.

14. A donor sheet according to any one of claims 8-13, comprising a plurality of layers of mutually different donor material in at least a part of the trench.

15. A method of manufacturing a donor sheet, the method comprising molding a transparent substrate from a master that defines a trench in the substrate, the trench having a property that varies as a function of position on the donor sheet, the property being at least one of an average trench depth, an average trench width, a deviation of a trench from an average trench track or a thickness or composition of material at a bottom of the trench and at least partially filling the trench with donor material.

16. A method according to claim 15, wherein the master defines a further trench and/or the trench has first and second trench parts, mutually different donor materials being applied in the trench and the further trench and/or in the first and second trench parts.

17. A method according to claim 15, comprising selectively applying a first donor material in first parts of the trench that have a first depth greater than a second depth of second parts of the trench and applying second donor material that is different from the first donor material over the first donor material in the first parts of the trenches and in the second parts of the trenches.

18. A manufacturing system for manufacturing a structure by means of light induced forward transfer, the manufacturing system comprising
- donor sheet holder;
- a light source configured to generate a light beam directed at a position for a back surface of a donor sheet defined by the donor sheet holder;
- a mechanism for moving the light beam and the donor sheet relative to each other
- a detector for detecting variation of a property of light reflected through the back surface; the property being at least one of a phase delay of the reflected light, a received intensity of the reflected light and an imbalance of the light reflected on respective sides of a predetermined track;
- a computer system coupled to the light source, the mechanism and the detector, the computer being configured to
- identify the sensing position on the donor sheet dependent on information derived from sensing by said detector;
- control said mechanism to move of a light spot position to a target position on the donor sheet dependent on the identified sensing position;
- control said light source to raise an intensity of light directed at the light spot position when the light spot has been moved according to the controlled movement
